# EUROPÄISCHE PATENTSCHRIFT

(11) **EP 1 903 318 B1**
(45) Veröffentlichungstag und Bekanntmachung des Hinweises auf die Patenterteilung: **25.03.2009**
(21) Anmeldenummer: 06019938.7
(22) Anmeldetag: 22.09.2006
(51) Int. Cl.: G01D 18/00, H03M 1/10

(54) **Erhöhung der Verfügbarkeit und Redundanz von Analogstromausgaben**
Improvement of reliability and redundancy of analog current sources
Amélioration de la fiabilité et de la redondance de sources de courant analogique

(43) Veröffentlichungstag der Anmeldung: 26.03.2008
(73) Patentinhaber: SIEMENS AKTIENGESELLSCHAFT, 80333 München (DE)
(72) Erfinder: Schwabe, Dietmar, 08496 Neumark (DE)

(56) Entgegenhaltungen:
- EP-A- 0 399 725
- WO-A-01/31790
- DE-A1-8102004 005 13
- US-A1- 2004 201 507

## Beschreibung

Die Erfindung betrifft ein Verfahren zur Erhöhung der Verfügbarkeit und Redundanz einer Analogstromausgabe sowie eine Analogstromausgabe mit erhöhter Verfügbarkeit und Redundanz.

Ein derartiges Verfahren bzw. eine derartige Analogstromausgabe kommt bei allen Baugruppen zum Einsatz, bei denen eine hohe Verfügbarkeit erforderlich oder gewünscht ist, wie dies beispielsweise bei Komponenten in der Automatisierungstechnik häufig der Fall ist.

Bisher wurde typischerweise die Redundanz einer Baugruppe durch Parallelschalten zweier Ausgänge realisiert. Dabei verhält sich ein Ausgang praktisch passiv, bis ein Fehler des ersten Ausgangs erkannt wird, Danach erfolgt eine Umschaltung auf den zweiten, redundanten Ausgang. Die EP 0 399 725 zeigt ein System mit zwei redundanten Stromquellen. Eine andere Variante besteht in der permanenten Anschaltung beider Ausgänge mit jeweils dem halben Strom und Abschalten des fehlerhaften Ausgangs bei gleichzeitiger Erhöhung des Stroms am intakten Ausgang.

Der Erfindung liegt die Aufgabe zugrunde, die Verfügbarkeit und zusätzlich das Redundanzverhalten einer Analogstromausgabe zu verbessern.

Diese Aufgabe wird gelöst durch ein Verfahren zur Erhöhung der Verfügbarkeit und Redundanz einer Analogstromausgabe,
- wobei eine erste Menge von Stromquellen zur Erzeugung eines Ausgangsstroms aktiv geschaltet wird,
- wobei von der ersten Menge zyklisch je eine Stromquelle auf Funktionstüchtigkeit überprüft wird und die jeweils anderen Stromquellen zu gleichen Teilen den Ausgangsstrom erzeugen und
- wobei bei Feststellung einer Funktionsuntüchtigkeit die entsprechende Stromquelle abgeschaltet und aus der ersten Menge entfernt wird.

Die Aufgabe wird weiter gelöst durch eine Analogstromausgabe mit den in Anspruch 8 genannten Merkmalen.

Erfindungsgemäß wird die Erzeugung des Ausgangsstroms zu gleichen Teilen auf mehrere Stromquellen aufgeteilt, die zusammen mit einer zusätzlichen Stromquelle eine erste Menge bilden, wodurch je eine Stromquelle zyklisch auf Funktionstüchtigkeit überprüft werden kann, ohne dass der Ausgangsstrom dadurch beeinträchtigt wird. Bei Auftreten einer Fehlfunktion, wie z.B. eines Ausfalls einer Stromquelle, fällt der Ausgangsstrom durch die Aufteilung der Erzeugung auf mehrere Stromquellen vorteilhafterweise nicht völlig ab. Durch die zyklische Überprüfung der Stromquellen kann die funktionsuntüchtige Stromquelle schnell aus der ersten Menge entfernt werden, wobei die verbleibenden Stromquellen weiterhin den vollen Ausgangsstrom liefern können, ohne dass sie durch eine erhöhte Energieabgabe einer stärkeren Belastung ausgesetzt wären. Es gibt daher praktisch keine Fehlererkennungs- und Umschaltzeiten und damit einen kontinuierlichen Stromfluss ohne Unterbrechungen.

In einer vorteilhaften Form der Ausgestaltung wird eine zweite Menge von Stromquellen in einem inaktiven Zustand bereitgehalten und bei Entfernung einer Stromquelle aus der ersten Menge eine Stromquelle aus der zweiten Menge aktiv geschaltet und der ersten Menge zugeordnet. Die Verfügbarkeit und Redundanz kann, je nach Anzahl der inaktiven (d.h. zusätzlichen) Stromquellen, feinstufig beliebig eingestellt werden.

In einer weiteren vorteilhaften Ausführungsform wird von der zweiten Menge zyklisch je eine Stromquelle auf Funktionstüchtigkeit überprüft. Damit kann bereits beim Zuschalten einer Stromquelle davon ausgegangen werden, dass diese funktioniert.

In einer weiteren vorteilhaften Ausführungsform wird die aus der zweiten Menge aktiv geschaltete und der ersten Menge zugeordnete Stromquelle direkt nach Abschaltung der funktionsuntüchtigen Stromquelle überprüft. Je nach Länge eines Zyklusschritts für die Überprüfung einer Stromquelle kann dies entweder, falls die Länge eines Zyklusschritts im Wesentlichen der benötigten Dauer für eine Überprüfung entspricht, im auf die Abschaltung folgenden Schritt erfolgen, oder, falls ein Zyklusschritt mindestens doppelt so lange dauert wie die benötigte Zeit für eine Überprüfung, auch noch im selben Schritt, in dem die Abschaltung erfolgt. In jedem Fall wird somit gewährleistet, dass die zur ersten Menge zugeordnete und aktiv geschaltete Stromquelle funktionstüchtig ist.

In einer weiteren vorteilhaften Ausführungsform wird zur Steuerung des beschriebenen Ablaufs eine programmierbare Schaltung verwendet. Die Steuerung kann dabei sowohl von einem Controller als auch von einer speziellen Ablaufsteuerung wie beispielsweise einem ASIC (Application Specific Integrated Circuit) oder einem FPGA (Field Programmable Gate Array) erfolgen.

In einer weiteren vorteilhaften Ausführung wird die Analogstromausgabe als integrierte Schaltung ausgeführt. In diesem Fall kann z.B. die Steuerung der Abläufe auf dem Chip mit integriert und kaskadierbar gestaltet werden, womit sich eine Verbesserung der Verfügbarkeit gegenüber einer externen Steuerung ergibt. Bei einer Kaskadierungsmöglichkeit kann zusätzlich die Steuerung redundant ausgelegt werden, was die Zuverlässigkeit weiter erhöht.

In einer weiteren vorteilhaften Ausführungsform ist eine zweite Steuerung redundant zur ersten Steuerung vorgesehen.

Hierdurch wird die Verfügbarkeit der Analogstromausgabe weiter erhöht.

In einer weiteren vorteilhaften Ausführungsform wird nach einer einstellbaren Anzahl funktionsuntüchtiger Stromquellen ein Warnhinweis ausgegeben. Für den Fall, dass nur eine erste Menge mit nur einer redundanten Stromquelle vorhanden ist, wird die einstellbare Anzahl sinnfälligerweise zu Eins gewählt. Weist die Ausführungsform hingegen noch eine zweite Menge von zusätzlichen Stromquellen auf, kann die Anzahl beispielsweise so gewählt werden, dass die Warnung frühzeitig genug erfolgt, damit zum nächsten Wartungstermin ein Auswechseln der Baugruppe erfolgen kann.

Im Folgenden wird die Erfindung anhand des in der Figur dargestellten Ausführungsbeispiels näher beschrieben und erläutert.

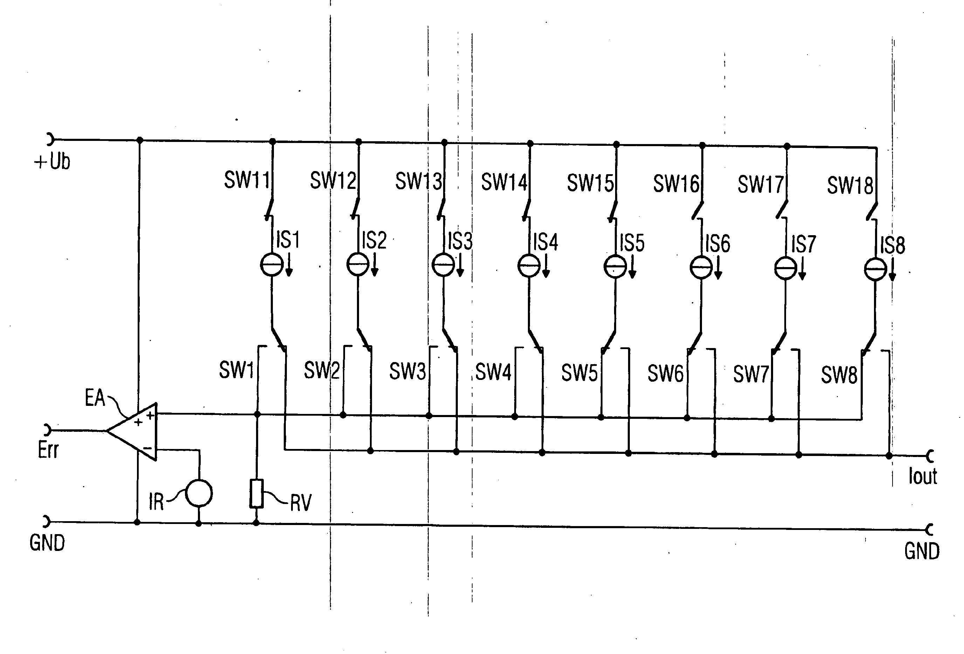

Fig 1 zeigt eine erfindungsgemäße Analogstromausgabe, die beispielhaft acht Stromquellen IS1-IS8 aufweist, in einer vereinfachten Darstellung, in der nur die wesentlichen Teile und nur die positiven Stromquellen IS1-IS8 gezeichnet sind. Jede der Stromquellen IS1-IS8 liefert ein Viertel des Ausgangsstromes Iout. Wie dargestellt befinden sich vier Stromquellen IS1-IS4 im Eingriff und liefern an Iout den vierfachen Stromwert der Einzelquelle. Zusätzlich ist die Stromquelle IS5 aktiv, trägt jedoch nicht zum Gesamtstrom Iout bei. Die Stromquellen IS1-IS5 bilden eine erste Menge von Stromquellen, die zur Erzeugung eines Ausgangsstroms Iout aktiv geschaltet sind, d.h. die Schalter SW11-SW15 sind geschlossen. Die Stromquellen IS6-IS8 bilden eine zweite Menge von Stromquellen, die in einem inaktiven Zustand bereitgehalten werden, d.h. die Schalter SW16-SW18 sind geöffnet. Erfindungsgemäß werden die fünf aktiven Stromquellen IS1-IS5 über eine entsprechende Logik zyklisch wie folgt an den Stromausgang Iout mittels der Wechselschalter SW1-SW5 geschaltet: Jeweils vier Stromquellen (IS1-IS4 in der Darstellung) an Iout und eine Stromquelle IS5 an den Widerstand Rv. Für die an Rv geschaltete Stromquelle IS5 wird ein Soll-Ist-Vergleich mittels Rv, der Referenzquelle IR und dem Fehlerverstärker EA durchgeführt. Somit werden innerhalb eines Zyklusses alle aktiven Stromquellen IS1-IS5 einmal überprüft und das Ergebnis über den Fehlerausgang Err einer Auswertung zur Verfügung gestellt. Wird ein Fehler erkannt, so kann die fehlerhafte, d.h. funktionsuntüchtige, Stromquelle (z.B. IS5) über den entsprechenden Schalter (z.B. SW15) sofort abgeschaltet werden und eine bisher inaktive, beispielsweise IS6 mittels SW16, zugeschaltet werden. Vorteilhafterweise wird dann zuerst die neu zugeschaltete Stromquelle IS6 auf Funktion getestet und dann der Zyklus zur Überprüfung auf Funktionstüchtigkeit unter Ausschließung der defekten und Einbeziehung der zugeschalteten Stromquelle IS6 weitergeführt. Für den Fall, dass die Prüfung einer Stromquelle IS5 auf Funktion nur die Hälfte der Zeit beansprucht, die für das Betreiben der aktiven Stromquellen IS1-IS4, d.h. einen Zyklusschritt, vorgesehen ist, so kann die aus der zweiten Menge stammende und nun aktiv geschaltete und der ersten Menge zugeordnete Stromquelle, z.B. IS6, auch innerhalb des Zyklusschritts getestet werden, in dem der Ausfall der Stromquelle IS5 festgestellt wurde. Es gibt somit praktisch keine Fehlererkennungs- und Umschaltzeiten und damit einen kontinuierlichen Stromfluss ohne Unterbrechungen. Die Verfügbarkeit und Redundanz kann feinstufig beliebig eingestellt werden - je nach Anzahl der inaktiven Stromquellen IS6-IS8. Die Steuerung des gesamten Ablaufs kann dabei sowohl von einem Controller als auch von einer speziellen Ablaufsteuerung wie beispielsweise einem ASIC (Application Specific Integrated Circuit) oder einem FPGA (Field Programmable Gate Array) erfolgen. Wird die Analogstromausgabe als integrierte Schaltung ausgeführt, so kann z.B. die Steuerung der Abläufe mitintegriert werden.

Zusammenfassend betrifft die Erfindung ein Verfahren zur Erhöhung der Verfügbarkeit und Redundanz einer Analogstromausgabe sowie eine Analogstromausgabe mit erhöhter Verfügbarkeit und Redundanz. Um die Verfügbarkeit und zusätzlich das Redundanzverhalten einer Analogstromausgabe zu verbessern wird vorgeschlagen, eine erste Menge von Stromquellen zur Erzeugung eines Ausgangsstroms aktiv zu schalten, von der ersten Menge zyklisch je eine Stromquelle auf Funktionstüchtigkeit zu überprüfen während die jeweils anderen Stromquellen zu gleichen Teilen den Ausgangsstrom erzeugen und bei Feststellung einer Funktionsuntüchtigkeit die entsprechende Stromquelle abzuschalten und aus der ersten Menge zu entfernen. Bei Auftreten einer Fehlfunktion, wie z.B. eines Ausfalls einer Stromquelle, fällt der Ausgangsstrom durch die Aufteilung der Erzeugung auf mehrere Stromquellen vorteilhafterweise nicht völlig ab. Durch die zyklische Überprüfung der Stromquellen kann die funktionsuntüchtige Stromquelle schnell aus der ersten Menge entfernt werden, wobei die verbleibenden Stromquellen weiterhin den vollen Ausgangsstrom liefern können, ohne dass sie durch eine erhöhte Energieabgabe einer stärkeren Belastung ausgesetzt wären. Es gibt daher praktisch keine Fehlererkennungs- und Umschaltzeiten und damit einen kontinuierlichen Stromfluss ohne Unterbrechungen.

## Patentansprüche

1. Verfahren zur Erhöhung der Verfügbarkeit und Redundanz einer Analogstromausgabe,
- wobei eine erste Menge von Stromquellen (IS1-IS5) zur Erzeugung eines Ausgangsstroms (Iout) aktiv geschaltet wird,
- wobei von der ersten Menge (IS1-IS5) zyklisch je eine Stromquelle (IS5) auf Funktionstüchtigkeit überprüft wird und die jeweils anderen Stromquellen (IS1-IS4) zu gleichen Teilen den Ausgangsstrom (Iout) erzeugen und
- wobei bei Feststellung einer Funktionsuntüchtigkeit die entsprechende Stromquelle abgeschaltet und aus der ersten Menge entfernt wird.

2. Verfahren nach Anspruch 1,
wobei eine zweite Menge von Stromquellen (IS6-IS8) in einem inaktiven Zustand bereitgehalten wird und wobei bei Entfernung einer Stromquelle aus der ersten Menge (IS1-IS5) eine Stromquelle aus der zweiten Menge (IS6-IS8) aktiv geschaltet und der ersten Menge zugeordnet wird.

3. Verfahren nach Anspruch 2,
wobei von der zweiten Menge (IS6-IS8) zyklisch je eine Stromquelle auf Funktionstüchtigkeit überprüft wird.

4. Verfahren nach Anspruch 2 oder 3,
wobei die aus der zweiten Menge aktiv geschaltete und der ersten Menge zugeordnete Stromquelle direkt nach Abschaltung der funktionsuntüchtigen Stromquelle überprüft wird.

5. Verfahren nach einem der vorhergehenden Ansprüche,
wobei zur Steuerung des beschriebenen Ablaufs eine programmierbare-Schaltung verwendet wird.

6. Verfahren nach einem der vorhergehenden Ansprüche,
wobei die Analogstromausgabe als integrierte Schaltung ausgeführt wird.

7. Verfahren nach einem der vorhergehenden Ansprüche,
wobei nach einer einstellbaren Anzahl funktionsuntüchtiger Stromquellen ein Warnhinweis ausgegeben wird.

8. Analogstromausgabe mit einer ersten Menge von Stromquellen (IS1-IS5) zur Erzeugung eines Ausgangsstroms (Iout), mit Mitteln zur zyklischen Überprüfung je einer Stromquelle (IS5) von der ersten Menge (IS1-IS5) auf Funktionstüchtigkeit, mit Mitteln zur Schaltung der Stromquellen (IS1-IS5) zur Erzeugung des Ausgangsstroms (Iout) durch die jeweils anderen Stromquellen (IS1-IS4) zu gleichen Teilen, mit Mitteln zur Abschaltung einer funktionsuntüchtigen Stromquelle und damit Entfernung dieser aus der ersten Menge (IS1-IS5) sowie mit einer ersten Steuerung zur Ansteuerung der genannten Mittel.

9. Analogstromausgabe nach Anspruch 8,
wobei eine zweite Menge von Stromquellen (IS6-IS8) in einem inaktiven Zustand vorgesehen ist und wobei Mittel zur Zuordnung einer Stromquelle aus der zweiten Menge (IS6-IS8) zur ersten Menge bei Entfernung einer funktionsuntüchtigen Stromquelle aus der ersten Menge (IS1-IS5) vorgesehen sind..

10. Analogstromausgabe nach Anspruch 9,
wobei Mittel zur zyklischen Überprüfung je einer Stromquelle von der zweiten Menge (IS6-IS8) auf Funktionstüchtigkeit vorgesehen sind.

11. Analogstromausgabe nach einem der Ansprüche 8 bis 10,
wobei die erste Steuerung als programmierbare Schaltung ausgeführt ist.

12. Analogstromausgabe nach einem der Ansprüche 8 bis 11,
wobei die Analogstromausgabe als integrierte Schaltung ausgeführt ist.

13. Analogstromausgabe nach einem der Ansprüche 8 bis 12,
wobei eine zweite Steuerung redundant zur ersten Steuerung vorgesehen ist.

14. Analogstromausgabe nach einem der Ansprüche 8 bis 13,
wobei Mittel zur Ausgabe eines Warnhinweises nach einer einstellbaren Anzahl funktionsuntüchtiger Stromquellen vorgesehen sind.

## Claims

1. Method for increasing the availability and redundancy of an analogue current output,
- with a first set of current sources (IS1-IS5) being switched to active to generate an output current (Iout),
- with one current source (IS5) respectively of the first set (IS1-IS5) being checked cyclically for serviceability and the other current sources (IS1-IS4) respectively generating the output current (Iout) in equal parts and
- where unserviceability is determined, the corresponding current source being disconnected and removed from the first set.

2. Method according to claim 1,
with a second set of current sources (IS6-IS8) being kept ready in an inactive state and when a current source is removed from the first set (IS1-IS5) a current source from the second set (IS6-IS8) being switched to active and being assigned to the first set.

3. Method according to claim 2,
with one current source respectively from the second set (IS6-IS8) being checked cyclically for serviceability.

4. Method according to claim 2 or 3,
with the current source from the second set switched to active and assigned to the first set being checked immediately after the unserviceable current source is disconnected.

5. Method according to one of the preceding claims,
with a programmable circuit being used to control the described sequence.

6. Method according to one of the preceding claims,
with the analogue current output being embodied as an integrated circuit.

7. Method according to one of the preceding claims,
with a warning message being output after an adjustable number of unserviceable current sources.

8. Analogue current output with a first set of current sources (IS1-IS5) for generating an output current (Iout), with means for the cyclical checking of one current source (IS5) respectively of the first set (IS1-IS5) for serviceability, with means for switching the current sources (IS1-IS5) so that the output current (Iout) can be generated by the other current sources (IS1-IS4) respectively in equal parts, with means for disconnecting an unserviceable current source and thus removing it from the first set (IS1-IS5) and with a first controller to activate the said means.

9. Analogue current output according to claim 8,
with a second set of current sources (IS6-IS8) being provided in an inactive state and with means being provided for assigning a current source from the second set (IS6-IS8) to the first set when an unserviceable current source is removed from the first set (IS1-IS5).

10. Analogue current output according to claim 9,
with means being provided for the cyclical checking of one current source respectively of the second set (IS6-IS8) for serviceability.

11. Analogue current output according to one of claims 8 to 10,
with the first controller being embodied as a programmable circuit.

12. Analogue current output according to one of claims 8 to 11,
with the analogue current output being embodied as an integrated circuit.

13. Analogue current output according to one of claims 8 to 12,
with a second controller being provided in a redundant manner in respect of the first controller.

14. Analogue current output according to one of claims 8 to 13,
with means being provided for outputting a warning message after an adjustable number of unserviceable current sources.

## Revendications

1. Procédé d'augmentation de la disponibilité et de la redondance d'une source de courant analogique
- dans lequel on monte de façon active un premier nombre de sources ( IS1 à IS5) de courant pour la production d'un courant ( Iout ) de sortie,
- dans lequel on contrôle cycliquement l'aptitude à fonctionner de respectivement l'une des sources ( IS5 ) de courant du premier nombre ( IS1 à IS5 ) et les autres sources ( IS1 à IS4 ) de courant produisent les mêmes parties du courant ( Iout ) de sortie et
- dans lequel, pour constater l'inaptitude à fonctionner, on débranche la source de courant correspondante et on la retire du premier nombre.

2. Procédé suivant la revendication 1,
dans lequel on maintient prête, dans un état inactif, un deuxième nombre de sources ( IS6 à IS8 ) de courant et dans lequel, lorsque l'on retire une source de courant du premier nombre ( IS1 à IS5 ), on monte de manière active une source de courant du deuxième nombre ( IS6 à IS8 ) et on l'affecte au premier nombre.

3. Procédé suivant la revendication 2,
dans lequel on contrôle cycliquement l'aptitude à fonctionner d'une source de courant du deuxième nombre ( IS6 à IS8 ) .

4. Procédé suivant la revendication 2 ou 3,
dans lequel on contrôle la source de courant montée de manière active dans le deuxième nombre et affectée au premier nombre après avoir débranché la source de courant inapte à fonctionner.

5. Procédé suivant l'une des revendications précédentes,
dans lequel, pour commander le déroulement décrit, on utilise un circuit programmable.

6. Procédé suivant l'une des revendications précédentes,
dans lequel on réalise la source de courant analogique sous la forme d'un circuit intégré.

7. Procédé suivant l'une des revendications précédentes, dans lequel après un nombre réglable de sources de courant inaptes à fonctionner, on émet une alerte.

8. Source de courant analogique ayant un premier nombre de sources ( IS1 à IS5 ) de courant pour la production d'un courant ( Iout ) de sortie, des moyens de contrôle cycliques de contrôle de l'aptitude à fonctionner de respectivement une source ( IS5 ) de courant du premier nombre ( IS1 à IS5 ), des moyens de mise en circuit des sources ( IS1 à IS5 ) de courant pour la production du courant ( Iout ) de sortie par les, respectivement, autres sources ( IS1 à IS4 ) de courant en des parties égales, des moyens pour mettre hors circuit une source de courant inapte à fonctionner et ainsi la retirer du premier nombre ( IS1 à IS5 ), ainsi qu'une première commande pour commander lesdits moyens.

9. Source de courant analogique suivant la revendication 8,
dans laquelle il est prévu un deuxième nombre de sources ( IS6 à IS8 ) de courant dans un état inactif, des moyens d'affectation d'une source de courant du deuxième nombre ( IS6 à IS8 ) au premier nombre étant prévus lors du retrait d'une source de courant inapte à fonctionner du premier nombre ( IS1 à IS5 ).

10. Source de courant analogique suivant la revendication 9,
dans laquelle il est prévu des moyens de contrôle cycliques de l'aptitude à fonctionner dans respectivement une source de courant du deuxième nombre ( IS6 à IS8 ).

11. Source de courant analogique suivant l'une des revendications 8 à 10,
dans laquelle la première commande est réalisée en circuit programmable.

12. Source de courant analogique suivant l'une des revendications 8 à 11,
dans laquelle la source de courant analogique est réalisée en circuit intégré.

13. Source de courant analogique suivant l'une des revendications 8 à 12,
dans laquelle une deuxième commande est prévue de manière redondante à la première commande.

14. Source de courant analogique suivant l'une des revendications 8 à 13,
dans laquelle il est prévu des moyens d'émission d'une alerte après un nombre réglable de sources de courant inaptes à fonctionner.
